# EUROPEAN PATENT SPECIFICATION

(11) **EP 2 993 713 B1**
(45) Date of publication and mention of the grant of the patent: **20.11.2019**
(21) Application number: 14183912.6
(22) Date of filing: 08.09.2014
(51) Int. Cl.: H01L 51/52, H01L 27/32

(54) **Lamp comprising two organic light emitting diodes**
Lampe mit zwei organischen Leuchtdioden
Lampe comprenant deux diodes luminescentes organiques

(43) Date of publication of application: 09.03.2016
(73) Proprietor: OLEDWorks GmbH, 52068 Aachen (DE)
(72) Inventor: Rickers, Christoph Dr., 52070 Aachen (DE)
(74) Representative: Gunzelmann, Rainer

(56) References cited:
- WO-A1-2013/035574
- US-A1- 2001 033 135
- US-A1- 2010 148 665

## Description

### FIELD OF THE INVENTION

The invention relates to a lamp comprising a first organic light emitting device (OLED) and a second OLED which are combined with their back sides to each other via a combiner in order to emit light in opposite directions, while also having a decreased inactive area.

### BACKGROUND OF THE INVENTION

US 2013/0154471 A1 discloses an organic light emitting diode device comprising organic layers, first and second electrode layers, a substrate layer and a wax layer. The first electrode layer is situated between the substrate layer and the organic layers, and the second electrode layer is situated between the organic layers and the wax layer.

Such a wax layer is considered to be disadvantageous.

US 2010/148665 A1 discloses an encapsulated optoelectronic device includes: a first barrier layer; an electroluminescence device configured to be coupled to the first barrier layer, and comprising a substrate and an electroluminescence element both defining a lateral side, and the electroluminescence element comprising a first electrode disposed on the substrate, a second electrode, and an optoelectronically active layer disposed between the first and second electrodes; a second barrier layer configured to be coupled to the electroluminescence device; and an adhesive configured to locate between and connect the first and second barrier layers, and at least to be coupled to the lateral side of the electroluminescence device to seal the electroluminescence device between the first and second barrier layers; a first conductive area disposed on the first barrier layer, located between the first and second barrier layers, and configured to be electrically coupled to the first electrode and electrically insulated from the second electrode and a second conductive area; the second conductive area disposed on the first barrier layer, located between the first and second barrier layers, and configured to be electrically coupled to the second electrode and electrically insulated from the first electrode and the first conductive area. A method for making the encapsulated optoelectronic device is also presented

US 2001/033135 A1 discloses an organic light emitting diode containing a first electrode, a second electrode, at least one organic light emitting layer, and an output coupler which reduces a Fresnel loss is provided. The index of refraction of the output coupler is matched to that of the adjacent layer of the device. The output coupler may be a dimpled transparent material or a composite layer containing light scattering particles to also reduce a critical angle loss.

WO 2013/035574 A1 discloses an organic EL illumination device (100) which has an organic EL panel (10) including a front surface (11) and a rear surface (12) and a metal plate for heat dissipation (40). The organic EL panel (10) has a front side end face (11R) continuing to the front surface, a rear side end face (12R) continuing to the rear surface which recedes in the direction toward the center of the organic EL panel (10) from the front side end face so as to form a step on the outer end face of the organic EL panel (10), an electrical connection section (14R) provided on a surface for connecting the front side end face with the rear side end face, and a seal material (15R). The seal material (15R) seals the electrical connection section in the recessed space and is provided so as to contact the outer edge (13R) in the portion where the metal plate for heat dissipation and the rear surface come into contact with each other, and fixes the metal plate for heat dissipation and the organic EL panel (10) in such a manner that the metal plate for heat dissipation adheres tightly to the rear surface.

### SUMMARY OF THE INVENTION

It is an object of the invention to provide an improved lamp.

According to the present invention, there is provided a lamp comprising a first and a second device, which are organic light emitting devices, each organic light emitting device having a front side and a back side, each organic light emitting device comprising
- organic layers and first and second electrode layers,
- a substrate layer forming a front side of the device, the first electrode layer being situated between the substrate layer and the organic layers,
- an encapsulation layer, the second electrode layer being situated between the encapsulation layer and the organic layers, and
- a metal layer forming the back side of the device, the encapsulation layer being situated between the metal layer and the second electrode layer, the metal layer comprising first and second parts which are electrically isolated from each other, the first part being electrically coupled to the first electrode layer (2) via a longer line realized through an electrically conductive glue besides the encapsulation layer (7), the second electrode (6) and the organic layers (3-5) and the second part (9) being electrically coupled to the second electrode layer (6) via another separated shorter line realized through the electrically conductive glue beside the encapsulation layer (7), the longer and shorter lines being arranged between the metal layer (8, 9) and the first an second electrodes (2, 6), respectively
wherein the lamp further comprises
- a combiner (21, 22) for combining where the first and second devices (41, 42) are combined with their back sides to each other via a combiner (21, 22) to emit light in opposite directions, whereby, when being combined via the combiner (21, 22), at least one of the first parts (8, 18) of the metal layers of the first and second devices (41, 42) is coupled to a first conductor (31) and at least one of the second parts (9, 19) of the metal layers of the first and second devices (41, 42) is coupled to a second conductor (32).

Each organic light emitting diode device comprises organic layers such as for example an emissive layer situated between two conductive layers. The organic light emitting diode device further comprises first and second electrode layers, a substrate layer and an encapsulation layer. The first electrode layer is situated between the substrate layer and the organic layers. The second electrode layer is situated between the encapsulation layer and the organic layers. The organic light emitting diode device further comprises a metal layer. The encapsulation layer is situated between the metal layer and the second electrode layer. The metal layer comprises first and second parts which are electrically isolated from each other. The first part of the metal layer is electrically coupled to the first electrode layer and the second part of the metal layer is electrically coupled to the second electrode layer. As a result, an organic light emitting diode device has been created comprising a metal layer that compared to the prior art wax layer starts to suffer from deformation at a much higher temperature when becoming hot or at a much higher pressure when being placed under pressure. This is a great improvement. In addition, the metal layer allows the first and second parts of it to be on the back side of the device. Then, respective first and second conductors, which are to be coupled to the respective first and second parts for providing power from a source to the device, can be located near the back side of the device. In case the metal layer for provision of contact towards the first and second conductors is placed on the back side of the device, the contacts that contribute to an inactive area in prior art devices can be removed. As a result, a decrease of the inactive area is achieved. This is considered to be a further great improvement.

An embodiment of the device is defined by the first part covering 10-90% of a surface of the metal layer, and the second part covering 10-90% of the surface. Of course, in case the first part covers 60% of the surface of the metal layer, the second part cannot cover more than 40% of the surface, when ignoring a small percentage of the surface necessary for introducing the electrical isolation. So, a sum of the percentages covered by the first and second parts will be at most 100% of the surface. Preferably, both first and second parts will each cover approximately 10-50% of the surface, more preferably approximately 25-50%, most preferably approximately 50%.

An embodiment of the device is defined by the substrate layer forming a front side of the device for emitting light, and the metal layer forming a back side of the device, wherein the first and second parts are configured to be coupled to first and second conductors respectively for receiving power from a source. Preferably, at a front side of the device, light is emitted, and at a back side of the device, power is supplied.

An embodiment of the device is defined by the metal layer being configured to spread heat. This embodiment is advantageous in that the metal layer is capable to spread heat.

An embodiment of the device is defined by the metal layer being configured to provide stability. This embodiment is advantageous in that the metal layer is capable to provide stability.

The metal layer may further be configured to improve a lateral current distribution by selecting a local resistance and/or a local thickness of the metal layer and/or by selecting proper contacting locations. The metal layer may further be configured to improve a heat dissipation of the device by making the metal layer rough and/or black.

An embodiment of the device is defined by further comprising - a diode for protecting the device against a wrong polarity.

A diode for protecting the device against a wrong polarity can be on top of an existing layer or may form part of a new layer to be added to the device between the metal layer and the substrate layer.

Such a lamp is for example a package of separate components to be installed and/or combined by a user. Two devices can be easily combined in a series combination or in a parallel combination. For the series combination, a first conductor is to be electrically coupled to a first part (anode) of a metal layer of a first device, a second part (cathode) of the metal layer of the first device is to be electrically coupled to a first part (anode) of a metal layer of a second device, and a second part (cathode) of the metal layer of the second device is to be electrically coupled to a second conductor. For the parallel combination, a first conductor is to be electrically coupled to first parts (anodes) of metal layers of first and second devices, and second parts (cathodes) of the metal layers of the first and second devices are to be electrically coupled to a second conductor.

A combiner allows said electrical couplings to be made and may for example comprise a conducting interconnection between a part of a metal layer of a device and a conductor and/or a conducting interconnection between different parts of metal layers of different devices etc.

The combiner may for example further comprise electronic components for improving, extending and/or protecting the series combination and/or the parallel combination etc.

An embodiment of the lamp is defined by the substrate layers forming front sides of the first and second devices for emitting light in opposite directions. A lamp emitting light in opposite directions is considered to be advantageous.

An embodiment of the lamp is defined by further comprising the first and second conductors. The first and second conductors may form part of the lamp or not.

An embodiment of the lamp is defined by the combiner comprising an isolating separator for separating the metal layers of the first and second devices. An isolating separator separates the metal layers of the first and second devices in an isolating way. After installment, the first and second devices contact opposite sides of each conductor, and the lamp can be shifted in a length direction of the conductors.

An embodiment of the lamp is defined by the isolating separator having a thickness equal to or smaller than a diameter of one or more of the first and second conductors. In case a thickness of an isolating separator is equal to or preferably a bit smaller than a diameter of one or more of the first and second conductors, by which diameter both first and second devices are separated from each other, a mechanical force will keep the first and second devices on the one hand and the first and second conductors on the other hand together / in place.

An embodiment of the lamp is defined by the isolating separator being made of flexible material or of resilient material. In case the separator is made of flexible material or of resilient material, the first and second devices on the one hand and the first and second conductors on the other hand can be clipped together.

An embodiment of the lamp is defined by the isolating separator comprising an adhesive or being glued to the metal layers of the first and second devices. An isolating separator may consist of an adhesive such as a double sided adhesive having a proper thickness or may comprise an adhesive situated on both sides of an intermediate part having a proper thickness. Such an intermediate part may also be glued to the metal layers of the first and second devices.

Preferably, each one of the first and second devices may further comprise a diode for protecting the device against a wrong polarity. Diodes for protecting the devices against wrong polarities can be integrated on top of an existing layer of each device or may form part of a new layer to be added to each device between the metal layer and the substrate layer.

A basic idea is that a metal layer is to be added to an organic light emitting diode device comprising organic, electrode, substrate and encapsulation layers, and that first and second electrically isolated parts of the metal layer are to be coupled to the electrode layers.

A problem to provide an improved lamp has been solved. A further advantage is that a halogen or two-conductor environment can be introduced for an organic light emitting diode device.

These and other aspects of the invention will be apparent from and elucidated with reference to the embodiments described hereinafter.

### BRIEF DESCRIPTION OF THE DRAWINGS

In the drawings:
- Fig. 1: shows a prior art device,
- Fig. 2: shows a device,
- Fig. 3: shows a first lamp,
- Fig. 4: shows a second lamp,
- Fig. 5: shows backsides of separate first and second devices,
- Fig. 6: shows the combination of first and second devices, and
- Fig. 7: shows combined first and second devices.

### DETAILED DESCRIPTION OF EMBODIMENTS

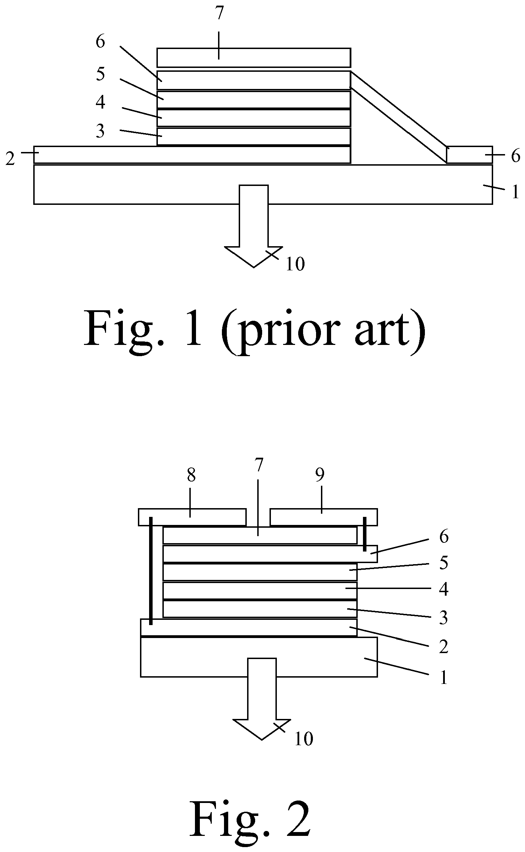

In the Fig. 1, a prior art device is shown, in cross section. The organic light emitting diode device 1-7 comprises a substrate layer 1 for emitting light 10, followed by a first electrode layer 2 such as for example an anode, followed by organic layers 3-5 such as for example two conductive layers 3 and 5 separated by an emissive layer 4, followed by a second electrode layer 6 such as for example a cathode, followed by an encapsulation layer 7. The first electrode layer 2 can be contacted at a left side of the device 1-7 and the second electrode layer 6 can be contacted at a right side of the device 1-7.

In a prior art situation, the encapsulation layer 7 may be a wax layer or may be followed by a wax layer, as for example disclosed in US 2013 / 0154471 A1. Such a wax layer is considered to be disadvantageous.

In the Fig. 2, a device is shown, in cross section. The organic light emitting diode device 1-9 comprises a substrate layer 1 for emitting light 10 at a front side of the device 1-9, followed by a first electrode layer 2 such as for example an anode, followed by organic layers 3-5 such as for example two conductive layers 3 and 5 separated by an emissive layer 4, followed by a second electrode layer 6 such as for example a cathode, followed by an encapsulation layer 7, followed by a metal layer 8, 9. The metal layer 8, 9 comprises first and second parts 8 and 9 which are electrically isolated from each other. The first part 8 is electrically coupled to the first electrode layer 2 as indicated by the longer thick line that may for example be realized through an electrically conductive glue and the second part 9 is electrically coupled to the second electrode layer 6 as indicated by the shorter thick line that may for example be realized through an electrically conductive glue. As a result, the first electrode layer 2 and the second electrode layer 6 can be contacted at a back side of the device 1-9 via the first and second parts 8 and 9 respectively.

Usually, the first part 8 covers 10-90% of a surface of the metal layer 8, 9, and the second part 9 covers 10-90% of the surface. The substrate layer 1 forms a front side of the device 1-9 for emitting light 10, and the metal layer 8, 9 forms a back side of the device 1-9. The first and second parts 8, 9 are configured to be coupled to first and second conductors respectively for receiving power from a source. The metal layer 8, 9 may be configured to spread heat and/or to provide stability. The device 1-9 may further comprise a diode for protecting the device 1-9 against a wrong polarity.

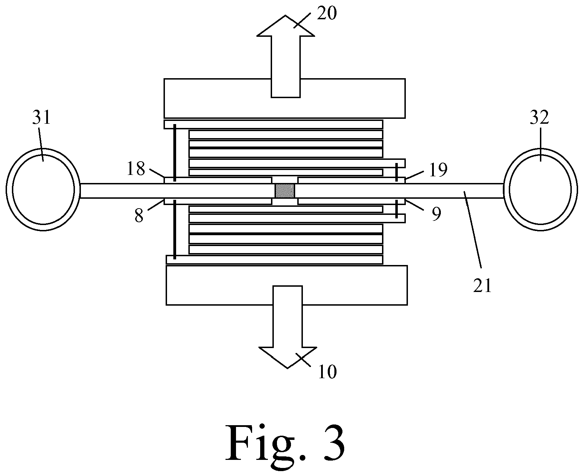

In the Fig. 3, a first lamp is shown. The first lamp comprises a first device as shown in the Fig. 2 with the first and second parts 8 and 9 and emits light 10 via its front side. The first lamp comprises a second device as shown in the Fig. 2 with first and second parts 18 and 19 and emits light 20 via its front side. The first and second devices are combined with their back sides to each other via a combiner 21. The combiner 21 for example comprises a first conducting interconnection for electrically coupling the first parts 8 and 18 to each other and to a first conductor 31. The combiner 21 for example comprises a second conducting interconnection for electrically coupling the second parts 9 and 19 to each other and to a second conductor 32. The first and second conducting interconnections are coupled to each other via an isolating interconnection as indicated by the grey area. This way, the first parts 8 and 18 are electrically coupled to the first conductor 31 and the second parts 9 and 19 are electrically coupled to the second conductor 32 for receiving power from a source. The respective first and second conducting interconnections may for example comprise respective first and second rings at their ends for contacting the respective first and second conductors 31 and 32 in a shiftable manner.

In the Fig. 3, the first and second devices are coupled in parallel but alternatively they may be coupled serially. Thereto, the combiner 21 and/or the parts 8, 9, 18, 19 are to be amended, for example by adapting one or more of the conducting and isolating interconnections and/or by relocating one or more of the parts 8, 9, 18, 19, such that the first conductor 31 is electrically coupled to the first part 8 (anode), the second part 9 (cathode) is electrically coupled to the first part 18 (anode), and the second part 19 (cathode) is electrically coupled to the second conductor 32. Other kinds of combiners 21 are not to be excluded.

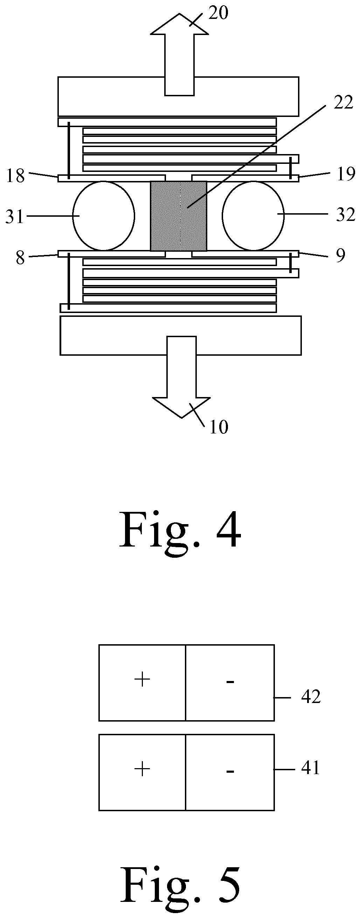

In the Fig. 4, a second lamp is shown, that differs from the one shown in the Fig. 3 in that the first and second devices are combined with their back sides to each other via a combiner 21, 22 in the form of an isolating separator 22. The isolating separator 22 for example comprises an isolating interconnection indicated by the grey area. The first conductor 31 is situated between and electrically coupled to the first parts 8 and 18 for electrically coupling the first parts 8 and 18 to each other. The second conductor 32 is situated between and electrically coupled to the second parts 9 and 19 for electrically coupling the second parts 9 and 19 to each other. This way, the first parts 8 and 18 are electrically coupled to the first conductor 31 and the second parts 9 and 19 are electrically coupled to the second conductor 32 for receiving power from a source. The respective first and second conductors 31 and 32 may for example be coupled to the respective first and second parts 8, 18, 9, 19 in a shiftable manner.

In the Fig. 4, the first and second devices are coupled in parallel but alternatively they may be coupled serially. Thereto, the combiner 21, 22 and/or the parts 8, 9, 18, 19 are to be amended, for example by adding one or more conducting interconnections and/or by relocating one or more of the parts 8, 9, 18, 19, such that the first conductor 31 is electrically coupled to the first part 8 (anode), the second part 9 (cathode) is electrically coupled to the first part 18 (anode), and the second part 19 (cathode) is electrically coupled to the second conductor 32. Other kinds of combiners 21, 22 are not to be excluded.

The lamps shown in the Fig. 3 and 4 emit light 10, 20 in opposite directions. The first and second conductors 31, 32 may form part of the lamps or not and may have a circular shape in cross section as shown or any other shape in cross section. The isolating separator 22 separates the metal layers of the first and second devices to allow the first and second conductors 31, 32 to be placed between the first and second devices. The isolating separator 22 may have a thickness equal to or smaller than a diameter of one or more of the first and second conductors 31, 32. The isolating separator 22 may be made of flexible material or of resilient material and may comprise an adhesive or may be glued to the metal layers of the first and second devices.

In the Fig. 5, backsides of separate first and second devices are shown. The first and second devices 41 and 42 have first and second parts indicated by plus and minus, each almost using 50% of the surface of the metal layer.

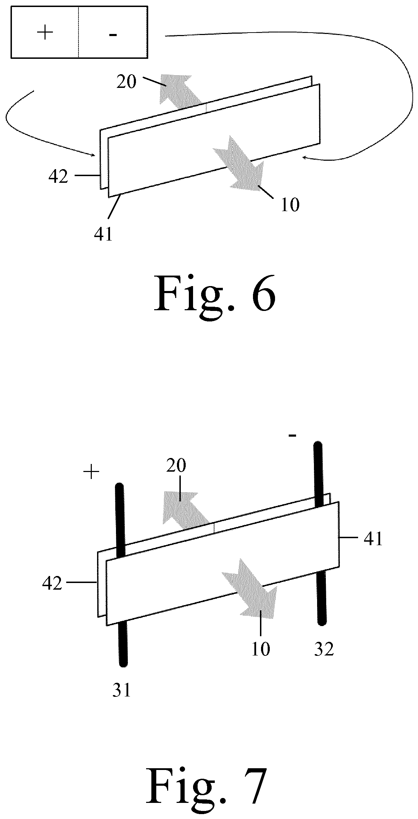

In the Fig. 6, the combination of first and second devices is shown. The first and second devices 41 and 42 from the Fig. 5 are in this particular example combined such that each plus is located opposite to the other plus, and each minus is located opposite to the other minus.

In the Fig. 7, combined first and second devices are shown. The first and second devices 41 and 42 from the Fig. 6 are in this particular example combined via an isolating separator not shown here such that the first and second conductors 31 and 32 are located between the first and second devices 41 and 42 as already described for the Fig. 4.

First and second elements can be coupled directly without a third element being in between and can be coupled indirectly via the third element.

Summarizing, organic light emitting diode devices 1-9 comprise substrate layers 1 at their front sides for emitting light 10, first electrode layers 2, organic layers 3-5, second electrode layers 6, encapsulation layers 7, and metal layers 8, 9 at their back sides. The metal layers 8, 9 comprise first and second parts 8, 9 coupled to the first and second electrode layers 2, 6 to allow contacting at the back sides. The parts 8, 9 are electrically isolated from each other. The metal layers 8, 9 may be configured to spread heat and to provide stability. Lamps may comprise two of these devices 41, 42 coupled back-to-back via a combiner 21, 22 such as for example an isolating separator 22 and may emit light 10, 20 in opposite directions. Halogen or two-conductor environments can be introduced for lamps comprising organic light emitting diode devices 1-9.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A lamp comprising
a first and a second device, which are organic light emitting diode devices (1-9, 41, 42), each organic light emitting diode having a front side and a back side, each organic light emitting diode comprising
- organic layers (3-5) and first and second electrode layers (2, 6),
- a substrate layer (1) forming a front side of the device, the first electrode layer (2) being situated between the substrate layer (1) and the organic layers (3-5),
- an encapsulation layer (7), the second electrode layer (6) being situated between the encapsulation layer (7) and the organic layers (3-5), and
- a metal layer (8, 9) forming the back side of the device, the encapsulation layer (7) being situated between the metal layer (8, 9) and the second electrode layer (6), the metal layer (8, 9) comprising first and second parts (8, 9) which are electrically isolated from each other, the first part (8) being electrically coupled to the first electrode layer (2) via a longer line realized through an electrically conductive glue besides the encapsulation layer (7), the second electrode (6) and the organic layers (3-5) and the second part (9) being electrically coupled to the second electrode layer (6) via another separated shorter line realized through the electrically conductive glue beside the encapsulation layer (7), the longer and shorter lines being arranged between the metal layer (8, 9) and the first and second electrodes (2, 6), respectively,
**characterized in that**
the lamp further comprises
- a combiner (21, 22) for combining the first and the second devices (41,42), where the first and second devices (41,42) are combined with their back sides to each other via a combiner (21, 22) to emit light in opposite directions, whereby, when being combined via the combiner (21, 22), at least one of the first parts (8, 18) of the metal layers of the first and second devices (41, 42) is coupled to a first conductor (31) and at least one of the second parts (9, 19) of the metal layers of the first and second devices (41,42) is coupled to a second conductor (32).

2. The lamp as defined in claim 1,
**characterized in that**
the first part (8) of each of the first and second device (1-9, 41, 42) covers 10-90% of a surface of the metal layer (8, 9), and the second part (9) of each of the first and second device (1-9, 41, 42) covers 10-90% of the surface.

3. The lamp as defined in claim 1,
**characterized in that**
the substrate layer (1) forms a front side of each of the first and second device (1-9,41, 42) for emitting light (10), and the metal layer (8, 9) forms a back side of each of the first and second device (1-9, 41, 42) wherein the first and second parts (8, 9) are configured to be coupled to first and second conductors (31, 32) respectively for receiving power from a source.

4. The lamp as defined in claim 1,
**characterized in that**
the metal layer (8, 9) of each of the first and second device (1-9, 41, 42) is made black and/or rough to spread heat.

5. The lamp as defined in claim 1,
**characterized in that**
a local resistance and/or local thickness of the metal layer (8, 9) of each of the first and second device (1-9, 41, 42) and or a proper contacting location is selected to improve a lateral current distribution.

6. The lamp as defined in claim 1,
**characterized in that**
each of the first and second device (1-9,41,42), further comprises a diode for protecting the device (1-9,41,42) against a wrong polarity.

7. The lamp as defined in claim 1, further comprising the first and second conductors (31, 32).

8. The lamp as defined in claim 1, the combiner (21, 22) comprising an isolating separator (22) for separating the metal layers of the first and second devices (41, 42).

9. The lamp as defined in claim 8,
the isolating separator (22) having a thickness equal to or smaller than a diameter of one or more of the first and second conductors (31, 32) by providing a mechanical force keeping the first and second devices (41, 42) on one hand and the first and second conductors (31, 32) on the other hand together in place

10. The lamp as defined in claim 8,
the isolating separator (22) being made of flexible material or of resilient material.

11. The lamp as defined in claim 8,
the isolating separator (22) comprising an adhesive or being glued to the metal layers of the first and second devices (41,42).

## Patentansprüche

1. Lampe, die umfasst
eine erste und eine zweite Vorrichtung, die organische lichtemittierende Diodenvorrichtungen (1-9, 41, 42) sind, wobei jede organische lichtemittierende Diode eine Vorderseite und eine Rückseite aufweist, wobei jede organische lichtemittierende Diode umfasst
- organische Schichten (3-5) und erste und zweite Elektrodenschichten (2, 6),
- eine Substratschicht (1), die eine Vorderseite der Vorrichtung bildet, wobei die erste Elektrodenschicht (2) zwischen der Substratschicht (1) und den organischen Schichten (3-5) angeordnet ist,
- eine Verkapselungsschicht (7), wobei sich die zweite Elektrodenschicht (6) zwischen der Verkapselungsschicht (7) und den organischen Schichten (3-5) befindet, und
- eine Metallschicht (8, 9), die die Rückseite der Vorrichtung bildet, wobei sich die Verkapselungsschicht (7) zwischen der Metallschicht (8, 9) und der zweiten Elektrodenschicht (6) befindet, wobei die Metallschicht (8, 9) erste und zweite Teile (8, 9) umfasst, die elektrisch voneinander isoliert sind, wobei der erste Teil (8) elektrisch mit der ersten Elektrodenschicht (2) über eine längere Leitung gekoppelt ist, die durch einen elektrisch leitfähigen Klebstoff neben der Verkapselungsschicht (7) realisiert ist, die zweite Elektrode (6) und die organischen Schichten (3-5) und der zweite Teil (9) elektrisch mit der zweiten Elektrodenschicht (6) über eine weitere getrennte kürzere Leitung gekoppelt sind, die durch den elektrisch leitfähigen Klebstoff neben der Verkapselungsschicht (7) realisiert ist, wobei die längeren und kürzeren Leitungen zwischen der Metallschicht (8, 9) und der ersten bzw. zweiten Elektrode (2, 6) angeordnet sind,
**dadurch gekennzeichnet, dass**
die Lampe ferner umfasst
- einen Kombinierer (21, 22) zum Kombinieren der ersten und zweiten Vorrichtungen (41, 42), wobei die ersten und zweiten Vorrichtungen (41, 42) mit ihren Rückseiten über einen Kombinierer (21, 22) miteinander kombiniert sind, um Licht in entgegengesetzte Richtungen zu emittieren, wobei, wenn sie über den Kombinierer (21, 22) kombiniert sind, mindestens eines der ersten Teile (8, 18) der Metallschichten der ersten und zweiten Vorrichtung (41, 42) mit einem ersten Leiter (31) und mindestens einem der zweiten Teile (9, 19) der Metallschichten der ersten und zweiten Vorrichtung (41, 42) mit einem zweiten Leiter (32) gekoppelt ist.

2. Lampe nach Anspruch 1,
**dadurch gekennzeichnet, dass**
das erste Teil (8) jeder der ersten und zweiten Vorrichtung (1-9, 41, 42) 10-90% einer Oberfläche der Metallschicht (8, 9) bedeckt und das zweite Teil (9) jeder der ersten und zweiten Vorrichtung (1-9, 41, 42) 10-90% der Oberfläche bedeckt.

3. Lampe nach Anspruch 1,
**dadurch gekennzeichnet, dass**
die Substratschicht (1) eine Vorderseite jeder der ersten und zweiten Vorrichtung (1-9, 41, 42) zum Emittieren von Licht (10) bildet, und die Metallschicht (8, 9) eine Rückseite jeder der ersten und zweiten Vorrichtung (1-9, 41, 42) bildet, wobei das erste und zweite Teil (8, 9) konfiguriert sind, um mit ersten und zweiten Leitern (31, 32) gekoppelt zu werden, um Energie von einer Quelle zu erhalten.

4. Lampe nach Anspruch 1,
**dadurch gekennzeichnet, dass**
die Metallschicht (8, 9) jeder der ersten und zweiten Vorrichtungen (1-9, 41, 42) schwarz und/oder rau gemacht ist, um Wärme zu verteilen.

5. Lampe nach Anspruch 1,
**dadurch gekennzeichnet, dass**
ein lokaler Widerstand und/oder eine lokale Dicke der Metallschicht (8, 9) jeder der ersten und zweiten Vorrichtungen (1-9, 41, 42) und/oder eine geeignete Kontaktstelle ausgewählt wird, um eine Querstromverteilung zu verbessern.

6. Lampe nach Anspruch 1,
**dadurch gekennzeichnet, dass**
jede der ersten und zweiten Vorrichtungen (1-9, 41, 42), ferner eine Diode zum Schutz der Vorrichtung (1-9, 41, 42) gegen eine falsche Polarität umfasst.

7. Lampe nach Anspruch 1, ferner umfassend den ersten und zweiten Leiter (31, 32).

8. Lampe nach Anspruch 1, wobei der Kombinierer (21, 22) einen Isolationsteiler (22) zum Trennen der Metallschichten der ersten und zweiten Vorrichtung (41, 42) umfasst.

9. Lampe nach Anspruch 8, wobei
der Isolationsteiler (22) einer Dicke aufweist, die gleich oder kleiner als ein Durchmesser eines oder mehrerer der ersten und zweiten Leiter (31, 32) ist, durch Bereitstellen einer mechanischen Kraft, die die erste und zweite Vorrichtung (41, 42) einerseits und die ersten und zweiten Leiter (31, 32) andererseits zusammen an ihrem Platz hält.

10. Lampe nach Anspruch 8, wobei
der Isolationsteiler (22) aus flexiblem Material oder aus elastischem Material hergestellt ist.

11. Die Lampe nach Anspruch 8, wobei
der Isolationsteiler (22) einen Klebstoff umfasst oder mit den Metallschichten der ersten und zweiten Vorrichtung (41, 42) verklebt ist.

## Revendications

1. Lampe comprenant
un premier et un second dispositif, qui sont des dispositifs à diode électroluminescente organiques (1 à 9, 41, 42), chaque diode électroluminescente organique ayant un côté avant et un côté arrière, chaque diode électroluminescente organique comprenant
- des couches organiques (3 à 5) et des première et seconde couches d'électrode (2, 6),
- une couche de substrat (1) formant un côté avant du dispositif, la première couche d'électrode (2) étant située entre la couche de substrat (1) et les couches organiques (3 à 5),
- une couche d'encapsulation (7), la seconde couche d'électrode (6) étant située entre la couche d'encapsulation (7) et les couches organiques (3 à 5), et
- une couche métallique (8, 9) formant le côté arrière du dispositif, la couche d'encapsulation (7) étant située entre la couche métallique (8, 9) et la seconde couche d'électrode (6), la couche métallique (8, 9) comprenant des première et seconde parties (8, 9) qui sont isolées électriquement l'une de l'autre, la première partie (8) étant couplée électriquement à la première couche d'électrode (2) via une ligne plus longue réalisée au moyen d'une colle électriquement conductrice en plus de la couche d'encapsulation (7), la seconde électrode (6) et les couches organiques (3 à 5) et la seconde partie (9) étant couplées électriquement à la seconde couche d'électrode (6) via une autre ligne plus courte séparée réalisée au moyen de la colle électriquement conductrice en plus de la couche d'encapsulation (7), les lignes plus longues et plus courtes étant disposées entre la couche métallique (8, 9) et les première et seconde électrodes (2, 6), respectivement,
**caractérisée en ce que**
la lampe comprend en outre
- un combinateur (21, 22) pour combiner les premier et second dispositifs (41, 42), où les premier et seconds dispositifs (41, 42) sont combinés dos à dos via un combinateur (21, 22) pour émettre de la lumière dans des directions opposées, grâce à quoi, lorsqu'ils sont combinés via le combinateur (21, 22), au moins l'une des premières parties (8, 18) des couches métalliques des premier et second dispositifs (41, 42) est couplée à un premier conducteur (31) et au moins l'une des secondes parties (9, 19) des couches métalliques des premier et second dispositifs (41, 42) est couplée à un second conducteur (32).

2. Lampe selon la revendication 1,
**caractérisée en ce que**
la première partie (8) de chacun des premier et second dispositifs (1 à 9, 41, 42) couvre 10 à 90 % d'une surface de la couche métallique (8, 9) et la seconde partie (9) de chacun des premier et second dispositifs (1 à 9, 41, 42) couvre 10 à 90 % de la surface.

3. Lampe selon la revendication 1,
**caractérisée en ce que**
la couche de substrat (1) forme un côté avant de chacun des premier et second dispositifs (1 à 9, 41, 42) pour émettre de la lumière (10), et la couche métallique (8, 9) forme un côté arrière de chacun des premier et second dispositifs (1 à 9, 41, 42), dans laquelle les première et seconde parties (8, 9) sont conçues pour être couplées respectivement aux premier et second conducteurs (31, 32) pour recevoir l'alimentation d'une source.

4. Lampe selon la revendication 1,
**caractérisée en ce que**
la couche métallique (8, 9) de chacun des premier et second dispositifs (1 à 9, 41, 42) est rendue noire et/ou rugueuse pour répartir la chaleur.

5. Lampe selon la revendication 1,
**caractérisée en ce que**
une résistance locale et/ou une épaisseur locale de la couche métallique (8, 9) de chacun des premier et second dispositifs (1 à 9, 41, 42) et/ou d'un emplacement de contact approprié est sélectionnée pour améliorer une distribution latérale du courant.

6. Lampe selon la revendication 1,
**caractérisée en ce que**
chacun des premier et second dispositifs (1 à 9, 41, 42) comprend en outre une diode pour protéger le dispositif (1 à 9, 41, 42) contre une mauvaise polarité.

7. Lampe selon la revendication 1, comprenant en outre les premier et second conducteurs (31, 32).

8. Lampe selon la revendication 1, le combinateur (21, 22) comprenant un séparateur d'isolement (22) pour séparer les couches métalliques des premier et second dispositifs (41, 42).

9. Lampe selon la revendication 8,
le séparateur d'isolement (22) ayant une épaisseur inférieure ou égale à un diamètre d'un ou plusieurs des premier et second conducteurs (31, 32) en fournissant une force mécanique maintenant les premier et second dispositifs (41, 42) d'une part et les premier et second conducteurs (31, 32) d'autre part en place ensemble.

10. Lampe selon la revendication 8,
le séparateur d'isolement (22) étant en matériau souple ou en matériau élastique.

11. Lampe selon la revendication 8,
le séparateur d'isolement (22) comprenant un adhésif ou étant collé aux couches métalliques des premier et second dispositifs (41, 42).
